(19) Europäisches Patentamt
European Patent Office
Office européen des brevets

(11) **EP 3 336 570 A1**

(12) **EUROPEAN PATENT APPLICATION**

(43) Date of publication:
**20.06.2018 Bulletin 2018/25**

(51) Int Cl.:
**G01R 33/50** (2006.01)  **G01R 33/56** (2006.01)
**G01R 33/561** (2006.01)  **G01R 33/565** (2006.01)
**G01R 33/48** (2006.01)  **G01R 33/483** (2006.01)

(21) Application number: **16204442.4**

(22) Date of filing: **15.12.2016**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**MA MD**

(71) Applicant: **Universität Heidelberg
69117 Heidelberg (DE)**

(72) Inventors:
• **RIEGER, Benedikt
68167 Mannheim (DE)**
• **WEINGÄRTNER, Sebastian
68167 Mannheim (DE)**

(74) Representative: **Müller-Boré & Partner
Patentanwälte PartG mbB
Friedenheimer Brücke 21
80639 München (DE)**

(54) **MAGNETIC RESONANCE FINGERPRINTING (MRF) USING ECHO-PLANAR IMAGING WITH SPOILING**

(57) The present invention relates to a method for analysing an object by means of nuclear magnetic resonance imaging. The method comprising
- issuing a pulse sequence (1) to an NMR apparatus, the pulse sequence (1) comprising a plurality of acquisition phases (3);
- within a respective acquisition phase (3), acquiring a corresponding set of imaging data; and
- quantifying at least one contrast parameter of the object based on the acquired sets of imaging data and simulated data;
wherein the acquisition phase (3) comprises the following steps in the given order:
-- an excitation step (5) for flipping a longitudinal magnetization of one or more nuclear spins in the object into a transversal plane by a variable flip-angle, thereby inducing a transversal magnetization;
-- an image readout step (6) for reading out the corresponding set of imaging data; and
-- a spoiling step (7) for depleting the transversal magnetization;
wherein a timing of the steps and/or the flip-angle is varied between at least two of the plurality of acquisition phases (3).

Further, the present invention relates to a corresponding computer program product, a control apparatus for NMR and to a nuclear magnetic resonance apparatus.

Fig. 1

EP 3 336 570 A1

**Description**

The present invention relates to a method for analysing an object by means of nuclear magnetic resonance (NMR) imaging. Further, the present invention relates to a corresponding computer program product, a control apparatus for NMR and to a nuclear magnetic resonance apparatus.

The quantification of tissue properties including the relaxation parameters such as T1, T2, and T2* using magnetic resonance imaging (MRI) has long been a major research goal, to facilitate interpatient comparability and quantitative diagnosis. The detection and staging of several diseases have been improved by the possibility of quantifying relaxation parameters. Examples include T1 and T2* mapping to investigate the iron content in the brain of patients suffering from Huntington's, Parkinson's, and Alzheimer's disease. Furthermore, T2* is used for blood oxygenation imaging of the brain and kidneys, and T1 for multiple system atrophy and diffuse ischemic and non-ischemic cardiomyopathy. However, long acquisition times prevent the integration of relaxation-parameter mapping into clinical brain scan protocols.

Recently, an emerging technique called magnetic resonance fingerprinting (MRF) and various extensions thereof have been introduced. In MRF, the acquisition of numerous baseline images with varying imaging parameters such as repetition time (TR) or flip angles (FA) yield spatially resolved characteristic signal evolutions which depend on the physical properties of the underlying tissue, such as relaxation times. Matching this "fingerprint" to a pre-computed dictionary that contains simulated signal profiles yields quantitative parameter maps.

The original implementation of the MRF paradigm is based on a balanced steady-state free precession (bSSFP) sequence design. The contrast in a bSSFP sequence allows for joint quantification of T1, T2, and off-resonance. Non-Cartesian imaging is conventionally employed to facilitate rapid image readout as required in a MRF sequence.

However, within the present invention, it turned out that the conventional sequence design has several drawbacks. For example, due to inherent properties of the non-Cartesian image readout, there exists a high sensitivity of MRF sequences to gradient deviations. Especially spiral trajectories, as used in most MRF sequences can suffer from detrimental effects on the image quality, caused by gradient inaccuracies. Implementing a Cartesian readout instead of a conventional non-Cartesian readout may potentially mitigate some of the sensitivities that are inherent to non-Cartesian acquisitions. However, merely replacing the non-Cartesian image readout by a Cartesian readout may suffer from long scan times, far beyond what is clinically acceptable.

Furthermore, within the present invention, it turned out that the spin-echo character of a conventionally used sequence can induce sensitivity to the choice of flip angles. In addition, the quantification based on a balanced sequence design can be sensitive to field inhomogeneities. Although a nonbalanced steadystate free precession (SSFP) imaging readout may be used instead of the conventional balanced sequence design in order to mitigate banding artifacts, this may result in a decreased signal-to-noise ratio (SNR).

Thus, it is an object of the present invention to overcome the above mentioned drawbacks and to provide an improved method for analysing or investigating an object or specimen by means of nuclear magnetic resonance imaging. In particular, it is an object of the present invention to provide an improved pulse-sequence for acquiring MRF data. The method and/or pulse sequence having an increased robustness and an increased usability. This object is solved by the subject-matter of the independent claims. Preferred embodiments are subject to the dependent claims.

According to one aspect of the present invention, a method for analysing an object by means of nuclear magnetic resonance imaging is provided. The method comprises:

- driving, by means of an NMR apparatus, a pulse sequence comprising a plurality of acquisition phases;
- within a respective acquisition phase, acquiring a corresponding set of imaging data; and
- quantifying at least one contrast parameter of the object based on the acquired sets of imaging data and simulated data;

wherein the acquisition phase comprises the following steps or modules in the given order:

-- an excitation step or module for flipping a longitudinal magnetization of one or more nuclear spins in the object into a transversal plane by a variable flip-angle, thereby inducing a transversal magnetization;
-- an image readout step or module for reading out the corresponding set of imaging data; and
-- a spoiling step or module for depleting the transversal magnetization;

wherein a timing of the steps or modules and/or the flip-angle is varied between at least two of the plurality of acquisition phases.

The object to be investigated preferably comprises one or more "resonant species", wherein a resonate species refers to an item (e.g. water, fat, tissue) that can be made to resonate using NMR. The object may for example be at least a part of a human or an animal.

A "pulse sequence" in the sense of the present invention is a sequence of pulses, such as excitation or radiofrequency (RF) pulses and/or magnetic field gradients, which are applied to the object to be investigated in order to generate a net magnetization that can be processed to an image by recording a current that is induced in a receiver coil of the NMR apparatus. The detected current may be converted using analog-to-digital (ADC) converters, wherein the corresponding events are referred to as ADC events. The totality of all RF pulses and magnetic field gradients and ADC events form the so called "pulse sequence".

A "module" in the sense of the present description is to be understood such that a certain step or procedure is carried out. Accordingly, the term "module" may be replaced by the term "step" or "procedure".

In general, RF pulses and magnetic field gradients can be combined in various ways to induce contrast weighting. Common building blocks can be used in pulse-sequences of different types, e.g. to convert contrast encoded in a longitudinal magnetization $M_z$ to a signal in a transverse magnetization $M_t$ that can be used for imaging.

According to the present invention, the pulse sequence comprises a plurality of acquisition phases. In particular, the pulse sequence may comprise N sets of acquisition phases, wherein N is an integer > 0 and wherein N is preferably larger than ten.

Within a respective acquisition phase, and particularly within each acquisition phase, a corresponding set of images and/or imaging data is acquired. In a next step, at least one contrast parameter, in particular the longitudinal relaxation time T1 and the transversal relaxation time T2*, of the object is quantified or determined based on the acquired sets of imaging data and simulated data. In particular, the acquired imaging data is reconstructed to quantitative maps for contrast parameters, e.g. T1 and T2*. In other words, the step of quantifying at least one contrast parameter of the object based on the acquired sets of imaging data and simulated data may encompass the step of reconstructing quantitative maps for contrast parameters, e.g. T1 and T2*, based on the acquired sets of imaging data and simulated data.

For the quantification of contrast parameters or for the reconstruction of quantitative maps for contrast parameters, different methods may be used, such as dictionary matching or simulated annealing. In particular, the contrast parameters may be quantified by comparing the acquired imaging data with the simulated data.

The simulated data may be pre-processed or pre-computed data. In particular, the simulated data represent an evolution of the magnetization. In particular, the simulated data represent signal evolutions for a plurality of different tissues or resonant species. The simulated data are preferably simulated or calculated based on mathematical and/or physical models using the Bloch-equations. The simulated data may be a dictionary as used by the MRF-technique.

An acquisition phase, i.e. at least one acquisition phase and particularly each acquisition phase, comprises at least an excitation step, an image readout step and a spoiling step.

Within the excitation step or excitation procedure, a RF-pulse is applied in order to flip a longitudinal magnetization of one or more nuclear spins in the object into a transversal plane by a variable, particularly pseudo-random, flip-angle, thereby inducing a transversal magnetization, i.e. a magnetization component in the transversal plane. The longitudinal magnetization is a magnetization in the direction (z-direction) of an applied uniform magnetic field, the polarizing magnetic field Bo. The transversal magnetization is a magnetization in the transversal plane (x-y-plane). When a substance such as a human tissue is subjected to the polarizing field Bo, the individual magnetic moments of the nuclear spins in the tissue attempt to align with this polarizing field, but precess about it in random order at their characteristic Larmor frequency. This results in a net magnetic moment $M_z$ in the direction of the polarizing field, while the randomly oriented magnetic components in the perpendicular or transverse plane (x-y plane) cancel each other. If the substance is subjected to an excitation field $B_1$ (RF-field) being applied in the x-y plane and having the Larmor frequency or a frequency near the Larmor frequency, the longitudinal magnetization $M_z$ may be rotated or flipped into the x-y plane, thereby resulting in a net transverse magnetic moment Mt. This net transverse magnetic moment Mt rotates or spins in the x-y plane at the Larmor frequency.

A "variable" flip-angle means within the present invention that the flip-angle can change from one acquisition phase to another. However, during one acquisition phase, the flip-angle is constant, i.e., during each one of the acquisition phases a distinct or predetermined flip-angle is used. Accordingly, the expression "variable" in the sense of the present invention means that the predetermined flip-angle of one acquisition phase may differ from the predetermined flip-angle of another acquisition phase. In particular, the variable flip angle may be a pseudo-random flip-angle. In other words, the flip-angle may change in a pseudo-random manner from one acquisition phase to the following or next acquisition phase. In other words, the flip-angle may change in a pseudo-random manner between two consecutive acquisition phases.

Within the image readout step or image readout procedure gradient pulses may be applied for reading out the corresponding set of imaging data.

By means of the spoiling step or spoiling procedure the transversal magnetization is depleted. Spoiling is used in the sequence to make it more robust. While spoiling reduces the overall signal strength throughout the pulse sequence, the sequence is more robust compared to non-spoiled sequences, as with non-spoiled sequences resulting phase errors can accumulate over time. Due to spoiling, the contrast from one acquisition phase to the next is only transferred by the longitudinal magnetization. Spoiling is performed after image readout but before the excitation. There are multiple methods to perform spoiling, e.g. gradient spoiling or RF-spoiling. In particular, spoiling may be performed by applying gradients with variable amplitudes at the end of each cycle. The strength of the spoiler gradient may be varied linearly or, more preferably, semi-randomly from view to view. RF spoiling involves applying a phase offset to each successive excitation pulse. It is noted that for the pulse sequence design according to the present invention it is not important with which method the spoiling is performed.

In view of the conventional MRF, it is noted that spoiling cannot be included into the pulse sequence without major changes, since the conventional pulse sequence is based on a balanced sequence design. A balanced sequence generally starts out with an RF excitation pulse of 90° or less and the spins in the steady state, by this meaning they are in a stable state. Prior to the next measurement, the gradients are balanced so their net value is zero. In a non-balanced sequence, however, as it is the case according to the present invention, the net value is non-zero at the end of each acquisition step.

Between at least two of the plurality of acquisition phases a timing of the steps (modules) and/or the flip-angle is varied. This changes the contrast of the acquired imaging data. The term "timing" particularly encompasses or refers to various characteristic times being crucial for NMR and/or MRI (herein referred to as NMR-times or MRI-times), such as an echo time, a repetition time, a waiting or delay time, and/or a time between the excitation step and the image readout step.

In other words, the method according to the present invention comprises acquiring of N sets of imaging data, using excitation by a flip angle, followed by an image readout and a depletion of the transversal magnetization. Each of the N images can differ in contrast as induced by, e.g., varying the flip angle and/or waiting times. Quantitative maps for contrast parameters, particularly for T1 and T2*, can then be reconstructed based on the imaging data.

According to the present invention, N images are rapidly acquired with varying contrast. To allow joint quantification of the T1 and T2* relaxation time the induced contrasts are generated by modifying contrast parameters of the acquired images independently and by depletion of the transverse magnetization (spoiling) at the end of each of the N imaging cycles.

Thus, by the method according to the present invention, and particularly by the pulse sequence design according to the present invention, it is possible to simultaneously quantify the relaxation parameters T1 and T2*, opposed to T1 and T2 as with the conventional MRF-technique.

Furthermore, the method according to the present invention has an increased robustness and an increased usability compared to conventional methods. This is because balanced sequence designs, as conventionally used, need to keep the magnetization in a controlled state to exert the so called "spin-echo character", i.e. the sensitization to a T2 decay. However, within the present invention it turned out that parameter variation can compromise this "spin-echo character" and accordingly the quantification accuracy. Moreover, the first moment of the magnetic field gradients needs to be balanced, which requires exact calibration of the gradient field strength. In commercially available MRI scanners, this cannot be achieved and cancelation of the gradient moments remains incomplete due to imperfections or non-linearities in the gradient fields. Thus, resulting phase errors can accumulate over time. A Spoiled sequence design on the other hand, as used according to the present invention, is robust towards the parameter choice, as the contrast is encoded in the longitudinal rather than the transverse magnetization. Furthermore, gradient moments are not to be balanced and, hence, inaccuracies are not affecting the sequence's fidelity. Lastly, thorough depletion of the transverse magnetization prevents any accumulate of such inaccuracies.

The method can be directly and with no further modification applied to all areas of imaging including neuroimaging, prostate imaging (e.g. prostate cancer), cartilage imaging or imaging of extremities. With minor modifications, e.g. the insertion of trigger and or gating events, relative to physiological signals, the sequence might be used for abdominal or cardiac applications.

In a preferred embodiment, the image readout step, and particularly an Echo Planar Imaging (EPI), is based on a Cartesian readout. In other words, the collection of imaging data is preferably performed on a Cartesian grid, for example by using Echo Planar Imaging.

In MRI image data is collected as samples in the space of spatial frequencies, the so called "k-Space". Magnetic gradient fields are employed to modulate the phase of the magnetization as a function of the spatial location, therefore, varying the sample location in the k-Space. A sufficient sampling of the k-Space allows for image generation by converting the spatial frequencies to image information by means of a Fourier-Transform. If the necessary image information in the k-space is sampled on a grid with orthogonal gridlines (i.e. "Cartesian"), the image acquisition is referred to as "Cartesian" imaging. Contrary to a Cartesian imaging, other trajectories are conventionally used to traverse through k-space and collect image data. If the resulting sampling locations on those trajectories do not resemble a "Cartesian" grid, the imaging is called "non-Cartesian". Acquiring data at sample locations on a spiral trajectory is for example referred to as "spiral imaging".

Non-Cartesian imaging, and spiral imaging in particular, as it is conventionally used for the MRF technique is sensitive to the exact sequence trajectory. Deviations are induced by gradient inaccuracies and delays in the gradient switching time. Accurate trajectory calibration is necessary for spiral imaging, and is not available on commercial MRI scanners. Its availability is restricted to few research centers world-wide. For a rapid Cartesian imaging on the other hand robust trajectory and image distortion correction algorithms have been proposed and are widely available, enabling the measurement with Cartesian techniques on every clinical MRI machine. Furthermore, sequences based on Cartesian imaging are more robust against hardware inaccuracies, providing more consistent image quality over a wide range of scan environments.

In particular, it has been found out within the present invention that by using spoiling in combination with a Cartesian readout, the pulse sequence is more robust in comparison to the previously proposed sequence design. Both non-Cartesian readout and balanced elements of the pulse sequence make the original MRF technique susceptible to artifacts due to system imperfections in conventional MRIs. Only by replacing both components by a Cartesian readout and spoiling (so no balanced design), the pulse sequence becomes more robust to system imperfections.

In a further preferred embodiment, the image readout step comprises or is an Echo Planar Imaging (EPI).

After a net magnetization is formed and excited, an ADC event will eventually be launched. Magnetic gradient fields that are turned on during the ADC event, allow traversing through the k-space during the data collection, thereby enabling the sampling of multiple locations for a single excitation. In Echo Planar Imaging the duration of the ADC-event is prolonged and magnetic gradient fields are active during the ADC event, in such a way that multiple lines on a Cartesian grid are sampled following a single excitation. This advantageously allows the image generation based on a single RF excitation of the net magnetization.

In a further preferred embodiment, spectral and or spatial selective pulses for chemical and/or regional saturation of tissue may be applied for an improved contrast. In particular, one or more acquisition phases, preferably each acquisition phase, further comprises a fat saturation step or a fat saturation procedure.

Fat saturation is advantageously used to suppress the off-resonance fat signals, as these cause artifacts in images. There are many different methods how to do a fat saturation, e.g. using a chemically selective pulse to saturate the fat signal. The fat saturation is preferably used before each excitation.

In a further preferred embodiment, the pulse sequence further comprises one or more preparation phases before or during the plurality of acquisition phases. The one or more preparation phases may comprise an initial magnetization preparation using, e.g., a T1 sensitizing step or module.

Preparations can be used at the beginning or during the pulse sequence. The aim of the preparation is to increase sensitivity of the measurement to a special contrast parameter. For example, it is possible to increase sensitivity of the relaxation parameter T1 by including an inversion pulse in order to flip the longitudinal magnetization by 180°. The preparation is optional, as the quantification of T1 and T2* also works without the preparation, though this module increases the precision of the quantification. The preparation can also include depletion of the transversal magnetization and fat suppression.

In a further preferred embodiment, the one or more preparation phases comprise one or more inversion pulses, particularly an initial magnetization preparation procedure using, e.g., a T1 sensitizing module. Additionally or alternatively, the one or more preparation phases comprise one or more depletion pulses for depleting the transversal magnetization. Additionally or alternatively, the one or more preparation phases comprise one or more fat suppression pulses. Thereby, the quality, robustness and/or sensitivity of the method can be further increased.

In a further preferred embodiment, the step of quantifying at least one contrast parameter of the object comprises jointly or simultaneously quantifying the longitudinal relaxation time T1 and the transversal relaxation time T2*. T1 and T2* refer to the well known relaxation times in NMR. T1 is also known as the spin-lattice relaxation time, while T2 is also known as the spin-spin relaxation time. T2* differs from T2 in that T2* is, contrary to T2, further influenced by a magnetic field inhomogeneity and/or magnetic field gradient irregularities. The T2* relaxation time is always shorter than the T2 relaxation time and is typically milliseconds for water samples in imaging magnets. It is noted that by means of a pulse sequence used in the conventional MRF-technique, only T1 and T2 can be quantified simultaneously. By means of the pulse sequence used in the method according to the present invention, however, the joint or simultaneous quantification of T1 and T2* is possible.

In a further preferred embodiment, the step of quantifying at least one contrast parameter of the object comprises a dictionary matching or a simulated annealing.

The signal during any of such pulse-sequences can be modeled using experimentally verified physical models, such as the "Bloch equations". Dictionary Matching refers to reconstruction of quantitative parameter maps, i.e. finding the contrast parameters that best describe the observed signal, by evaluating the pulse-sequence model at a defined set of parameters. The matching parameters are then chosen as the ones which produce the least deviation from the measured signal. This resembles a grid search minimizing the difference between the pulse-sequence model and the acquired signal. Alternative minimization algorithms are well known and can be applied to this optimization task. The main advantages of dictionary matching are the ease of implementation, as well as the robustness against local minima. The usage of pre-computed dictionaries also offers computational advantages if the objective function is computationally expensive, i.e. the pulse-sequence model is computationally expensive to evaluate.

Simulated Annealing is an alternative optimization technique, where the search space (i.e. the parameter space) is evaluated at pseudo-random locations. The optimization algorithm starts from a defined point in the search space. The next search location is then defined to lie in a neighborhood around the current putative minimum. The size of this neighborhood is reduced over time, as the putative minimum gets refined. This optimization has been shown to be robust to local minima, while providing an ordered search and avoiding unnecessary function evaluations is areas that are not of interest.

In a further preferred embodiment, the spoiling step or module is performed directly, i.e. without any further steps or modules in between, after performing the image readout step. Furthermore, the spoiling step is preferably performed before performing a possible next excitation step or an excitation step which belongs to a possible next acquisition phase.

In a further preferred embodiment, the spoiling step comprises gradient spoiling or radio frequency spoiling. Gradient spoiling is performed by applying gradients with variable amplitudes at the end of each cycle just before the next RF (radio frequency) pulse. The strength of the spoiler gradient is varied linearly or semi-randomly from view to view. Radio frequency (RF) spoiling involves applying a phase offset to each successive excitation pulse.

In a further preferred embodiment, the applied pulse sequence is based on a non-balanced sequence design. As already discussed above, a pulse sequence which is based on a non-balanced sequence design becomes more robust to system imperfections.

According to a further aspect of the present invention, a computer program product is provided, the computer program product comprising a computer readable storage medium, particularly a non-transitory readable storage medium, having encoded thereon instructions that, when executed on a processor, cause the processor to perform a method according to the present invention.

According to a further aspect of the present invention, there is provided a control apparatus for NMR comprising a processor or a computer being configured to perform the method according to the present invention.

According to a further aspect of the present invention, there is provided a nuclear magnetic resonance apparatus comprising:

- a magnet system for generating a main magnetic field;
- a gradient system for generating gradient fields;
- a radio frequency system for generating radio frequency pulses; and
- a control apparatus comprising a processor or a computer being configured to perform the method according to the present invention.

The main magnetic field may be a uniform and/or polarizing magnetic field $B_0$, which is particularly directed into the z-direction. The gradient system and/or the radio frequency system may generate an excitation field $B_1$ (RF-field), particularly in the x-y-plane.

For the above mentioned further independent aspect and in particular for preferred embodiments in this regard, the explanations given above or below concerning the embodiments of the first aspect also hold true. In particular, for one independent aspect of the present invention and for preferred embodiments in this regard, the explanations given above and below concerning the embodiments of the respective other aspects also hold true.

Individual embodiments for solving the problem are described by way of example below with reference to the figures. In this case, the individual embodiments described have in part features which are not absolutely necessary for implementing the claimed subject matter, but which provide desired properties in specific applications. In this regard embodiments which do not have all the features of the embodiments described below are also intended to be regarded as disclosed in a manner coming under the technical teaching described. Furthermore, in order to avoid unnecessary repetitions, specific features are mentioned only with regard to individual embodiments from among the embodiments described below. It is pointed out that the individual embodiments are therefore intended to be considered not only by themselves but also in a joint consideration. On the basis of this joint consideration the person skilled in the art will recognize that individual embodiments can also be modified by inclusion of individual or a plurality of features of other embodiments. It is pointed out that a systematic combination of the individual embodiments with individual or a plurality of features described with regard to other embodiments may be desirable and expedient and is therefore intended to be taken into account and also to be regarded as encompassed by the description.

Brief description of the figures

The above and other objects, features and advantages of the present invention will become more apparent upon reading of the following description of preferred embodiments and accompanying drawings. Other features and advantages of the subject-matter described herein will be apparent from the description and the drawings and from the claims. It should be understood that even though embodiments are separately described, single features and functionalities thereof may be combined without prejudice to additional embodiments. The present disclosure is illustrated by way of example and not limited by the accompanying figures.

Preferred embodiments of the present invention are exemplarily described regarding the following figures:

Fig. 1    shows a schematic representation of a pulse sequence as used in the method according to a preferred embodiment of the present invention;

Fig. 2    A) shows a schematic diagram of a pulse sequence according to a preferred embodiment, similar to Fig. 1;

B) shows a schematic diagram of corresponding pulses applied by a radio frequency system and a gradient system of an NMR apparatus;

C) shows exemplary profiles of the flip angle variations;

D) shows exemplary profiles of the echo time variations;

Fig. 3    A) shows exemplary fingerprints from a simulated dictionary for a range of T1 and T2* values;

B) shows the quantification precision in dependence of the maximum TE time of the TE pattern for a variety of T2* values (T1 = 1000ms), wherein for the emphasized curve T2* = 150 ms; For short T2* values a TE pattern with small $TE_{max}$ provides sufficient precision, this does not hold for long T2* values;

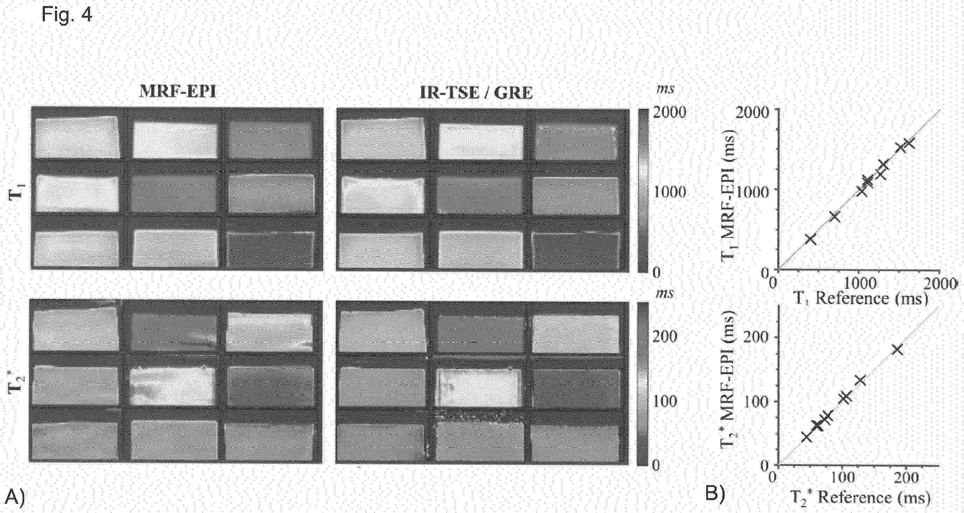

Fig. 4    A) shows T1 and T2* maps obtained in phantom measurements using MRF-EPI according to a preferred embodiment of the method according to the present invention and the respective reference method IR-TSE and GRE;

B) shows a comparison of T1 and T2* values of MRF-EPI according to a preferred embodiment of the method according to the present invention with the reference methods, showing good agreement between the average relaxation times in all phantoms;

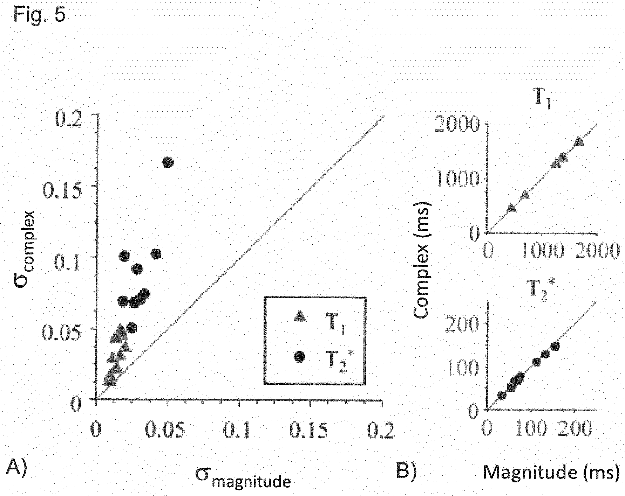

Fig. 5    A) shows the quantification variance of the phantoms for complex and magnitude matching. Complex dictionary matching leads to a higher quantification variance than magnitude matching;

B) shows measurement results illustrating that the quantified relaxation times T1 and T2* of the phantoms are nearly identical for complex and magnitude matching;

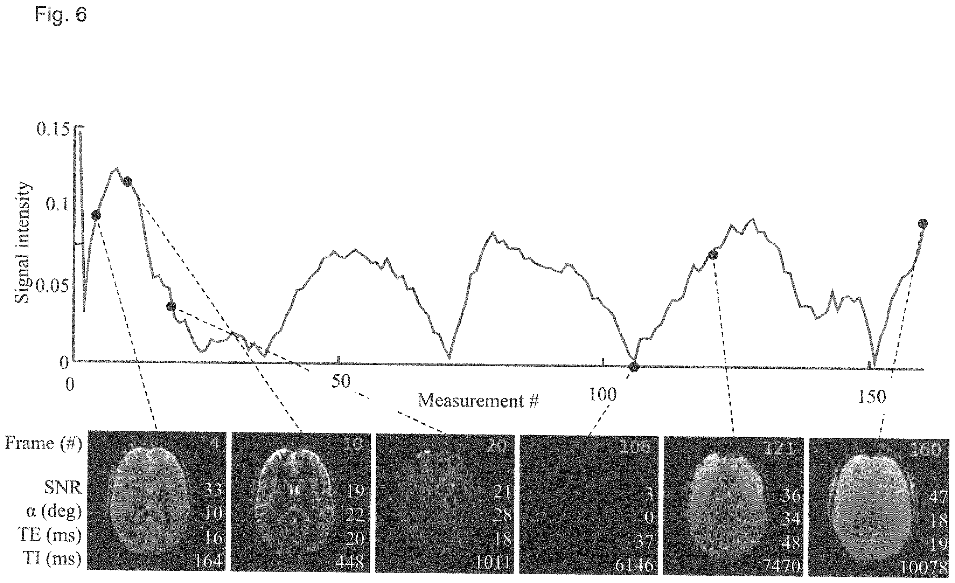

Fig. 6    shows a fingerprint from one voxel of a healthy object or subject (male, 30 years old) and exemplary images with corresponding TE, TI (scan time since inversion pulse), flip angle $\alpha$ and SNR, reconstructed from individual EPI readouts according to a preferred embodiment of the method according to the present invention. The images showing highly varying contrast over the course of the measurement. Strongly T1 weighted contrast is observed in the beginning of the measurement (#4, #10), while increasing T2* weighting is observed at the end of the sequence (#121, #160);

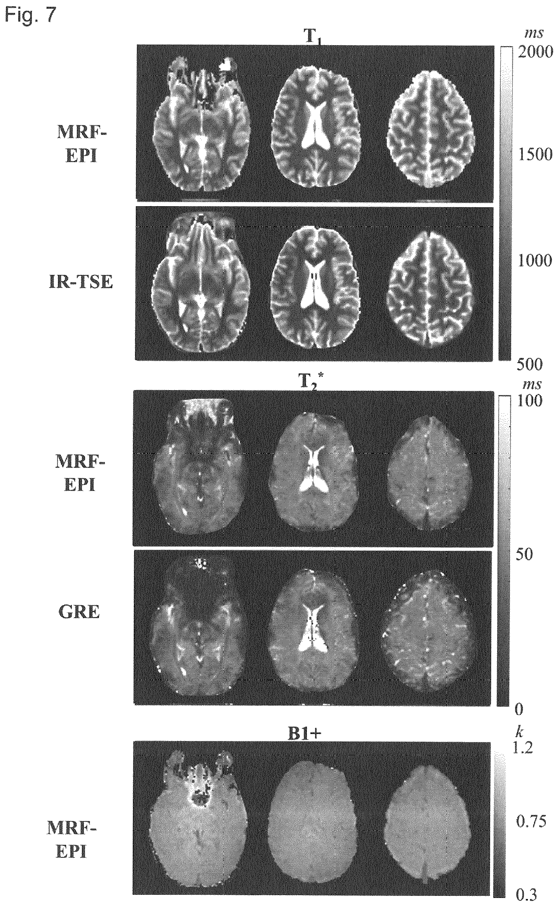

Fig. 7    shows T1, T2* and B1+ maps generated with MRF-EPI according to a preferred embodiment of the method according to the present invention and the reference methods IR-TSE (T1) and GRE (T2*) in a healthy volunteer (female, 25 years old). Good homogeneity is observed within the gray and white matter of the MRF-EPI T1 map. The T2* maps clearly reflect intra-cerebral susceptibilities, and shortened T2* times are observed in the vicinity to tissue air transitions, e.g. at the auditory canal or the sinus.

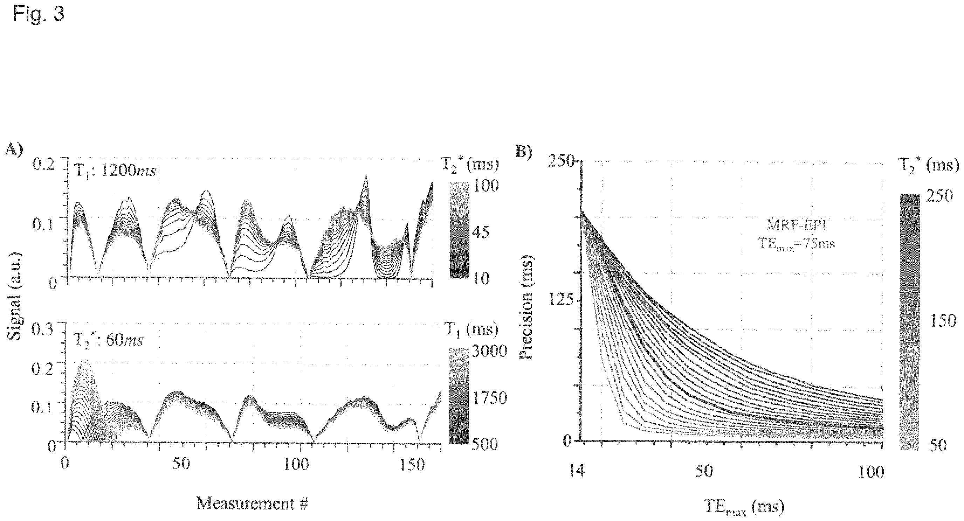

It is noted that **Figs. 3, 4, 6 and 7** include quantitative diagrams and/or photographs, which are helpful to illustrate and understand the present invention. These figures cannot be presented otherwise, e.g. as mere black and white line drawings.

Detailed description of the figures

The following detailed description relates to exemplary embodiments of the present invention. Other embodiments of the invention are possible within the scope of the invention as defined by the appended claims. Throughout the figures, same reference signs are used for the same or similar elements.

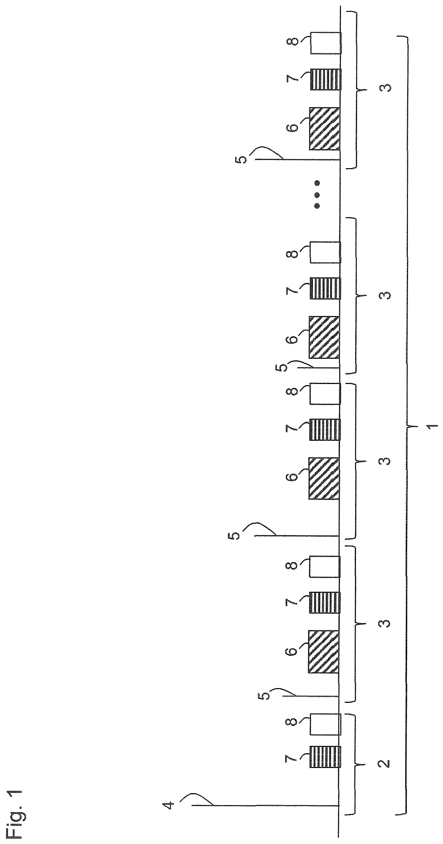

Fig. 1 shows a schematic representation of a pulse sequence 1 as used in the method according to a preferred embodiment of the present invention. According to the method of the present invention, a pulse sequence 1 such as exemplarily shown in Fig. 1 is driven by means of an NMR apparatus (not shown).

The pulse sequence 1 comprises a preparation phase 2 and a plurality of acquisition phases 3. Within the acquisition phases 3, a plurality (i.e. N sets) of imaging data are acquired using excitation by an excitation module 5, followed by an image readout module 6, depletion of the transversal magnetization by means of a spoiling module 7 and fat suppression by means of a fat suppression module 8.

In the following, the different phases and modules of the pulse sequence 1 are described:

Preparation phase 2: Preparations can be used at the beginning or during the pulse sequence 1. The aim of the preparation is to increase sensitivity of the measurement to a special parameter, e.g. it is possible to increase sensitivity of the relaxation parameter T1 by including an inversion pulse 4 which flips the longitudinal magnetization by 180°. The preparation is optional, as the quantification of T1 and T2* also works without the preparation, though this module increases the precision of the quantification. The preparation can also include depletion of the transversal magnetization by means of a spoiling procedure 7 and fat suppression by means of a fat suppression procedure 8.

Acquisition phase 3 (acquisition of N sets of imaging data): This phase consists of an excitation module, i.e. an excitation pulse 5, followed by image readout 6, depletion of the transversal magnetization 7 and fat suppression 8. This phase is applied N times after each other. By varying the flip angle of the excitation pulse 5 and the timing of the blocks or modules within this phase 3 (e.g. changing the time between the excitation pulse 5 and the image readout 6), the contrast of the image data changes. The flip angles of the excitation pulse 5 and the timing of the blocks within the acquisition phase 3 have to change throughout the measurement, as by this contrast variation is induced.

While timing does not necessarily need to change with each new acquisition phase 3 over the course of the pulse sequence 1 with N blocks, at least two different timings need to be used. The acquisition phase 3 is preferably applied at least 10 times. There is no upper limit how often the phase is applied.

Inversion pulse 4: Applying an inversion pulse 4 is an exemplary magnetization preparation for T1. The inversion pulse 4 flips the longitudinal magnetization by 180°.

Excitation module 5: The excitation module 5 comprising an excitation pulse is used to flip some or all of the longitudinal magnetization into the transversal plane. During the pulse sequence 1 N excitation pulses 5 are played with various flip angles. While the flip angles do not necessarily need to change with each new acquisition phase 3, over the course of the pulse sequence 1 with N excitation, at least two different flip angles need to be used. Generally lower flip angles (< 60 degree) should be used, as the repetitive use of high flip angles will cause the magnetization to decline. Nevertheless, the use of a few high flip angles (>=60 degree) can make the sequence more robust, as by this, e.g., the inhomogeneous magnetic transmit field can be measured.

Image readout module 6: Collection of image data is performed on a Cartesian grid using Echo Planar Imaging (EPI). The advantage of using EPI based on a Cartesian is that robust trajectory and image distortion correction algorithms are widely available, enabling the measurement with Cartesian techniques on every clinical MRI machine. Hence, sequences based on Cartesian imaging have been shown to be more robust against hardware inaccuracies, providing more consistent image quality over a wide range of scan environments. Non-Cartesian imaging on the other hand, and spiral imaging in particular, is sensitive to the exact sequence trajectory. Deviations are induced by gradient inaccuracies and delays in the gradient switching time. Accurate trajectory calibration is necessary for spiral imaging, and is not available on commercial MRI scanners. Its availability is restricted to few research centers world-wide. Generally non-Cartesian imaging can be used in the pulse sequence.

Spoiling module 7 (depletion of the transversal magnetization): Spoiling is used in the sequence to make it more robust. While spoiling reduces the overall signal strength throughout the pulse sequence 1, the sequence is more robust compared to non-spoiled sequences, as with non-spoiled sequences resulting phase errors can accumulate over time. Due to spoiling, the contrast from one acquisition phase 3 to the next is only transferred by the longitudinal magnetization. Spoiling needs to be performed after an image readout 6 and before an excitation 5. There are multiple methods to perform spoiling, e.g. gradient spoiling or RF-spoiling. For the pulse sequence design, it is not essential with which method the spoiling is performed.

Fat saturation module 8: Fat saturation is used to suppress the off-resonance fat signals, as these cause artifacts in images. Fat suppression can be performed by many different well known methods such as using a chemically selective pulse to saturate the fat signal.

Thus, in the method according to a preferred embodiment of the present invention, a pulse sequence 1 is applied, in which the magnetization is initially prepared with a T1 sensitizing module (e.g. inversion or saturation pulse). Subsequently, N images are rapidly acquired with varying contrast. To allow joint quantification of the T1 and T2* time, the induced contrasts are generated by modifying contrast parameters of each image independently and by depletion of the transverse magnetization (spoiling) at the end of each of the N imaging cycles.

In particular, an MRF strategy (MRF-EPI) as proposed by the present invention according to a preferred embodiment is based on the acquisition of a series of gradient echo-EPI images with varying flip angles (FAs) and echo times (TEs) to enable the joint quantification of T1 and T2*. To optimize scan-time, minimal TR may be chosen for any given TE.

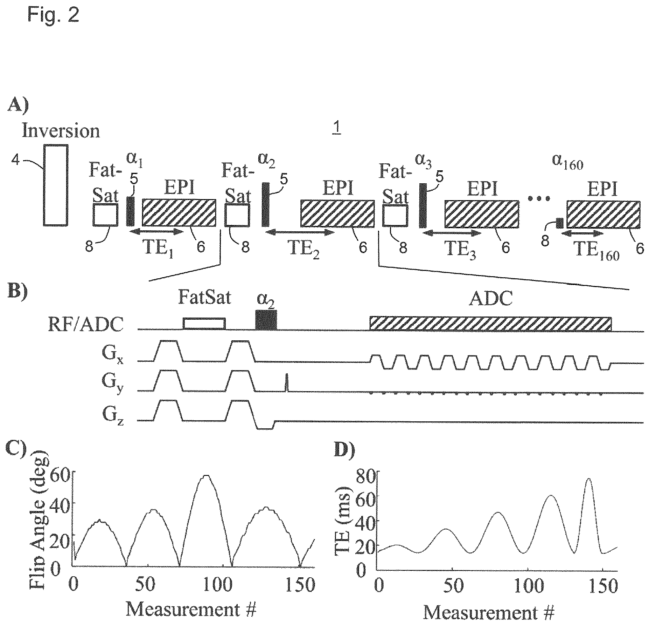

**Fig. 2A** shows a schematic diagram of the MRF-EPI with multiple EPI readouts, each with a different echo time TE and flip angle $\alpha$. As shown in the sequence diagram of Fig. 2A, a single nonselective adiabatic hyperbolic secant inversion pulse is applied at the beginning of the sequence followed by multiple EPI readouts 6. To suppress chemical-shift artifacts commonly observed with EPI sequences, a fat suppression 5 using spectrally-selective saturation is applied before each excitation 5. To eliminate residual transverse magnetization from the non-selective excitation, crusher gradients with equal polarity are performed before and after the saturation pulse 5. Additionally, RF spoiling (not explicitly shown in Fig. 1A) is included in the excitation pulse 5, e.g. with a phase increment of 50°. It is noted that in Fig. 2A gradient spoiling and fat saturation are illustrated as only one block or module, while in Fig. 1 the spoiling and fat saturation are shown as separate modules. In the example of Fig. 2, the number N of imaging data sets or measurements is 160.

**Fig. 2B** shows a schematic diagram of pulses applied by a radio frequency (RF) and analog-to-digital (ADC) system as well as a gradient system of an NMR apparatus in order to implement the pulse sequence 1 according to Fig. 2A, the gradient system comprising magnetic field gradients $G_x$, Gy and $G_z$. As shown in Fig. 2B, each EPI excitation module 5 and readout module 6 is preceded by a fat saturation module 8 including gradient spoiling. The technical implementation of the sequence shown in Fig. 2A by means of the field gradients $G_x$, Gy and $G_z$ is standard in the art and thus not further described herein.

The flip angles of the baseline images can be chosen in a pseudo-random manner. An example is shown in **Fig. 2C,** where an exemplary profile of the flip angle variation is illustrated. The flip angle varies throughout the measurements, i.e. throughout the acquisition phases.

**Fig. 2D** shows an exemplary profile of echo time variations that can be used for MRF measurements. The echo time (TE) varies throughout the measurements, i.e. throughout the acquisition phases. A range of TEs from 14-75ms is preferably chosen, which results in additional T1 and T2* weighting in the proposed sequence design. The distribution of TEs, as shown in Fig. 2D, may be empirically selected with a majority of short TEs to result in good SNR and short scan-times, a few long TEs to increase sensitivity to tissues with long T2* values, and an alternating pattern to create large contrast variations.

Thus, according to the present invention, the acquisition of several images with diverse contrasts is proposed in rapid succession enabled by depletion of the transversal magnetization and ultra-short imaging readout (e.g. EPI) to allow for the extraction of quantitative parameter maps.

In the following, it is described in detail how the simulated data can be obtained and matched to the acquired image data. Although other methods such as simulated annealing may be used, the following description exemplarily refers to MRF using a dictionary matching. Accordingly, a possible generation of the dictionary as well as details relating to the pattern validation, the pattern matching and the sequence parameters as used exemplarily by the inventors within the present invention are described in the following. Furthermore, phantom experiments and in-vivo experiments that have been performed by the inventors are presented and discussed in order to illustrate the potential and usability of the method according to the present invention.

Dictionary:

The dictionary may be generated off-line by simulating the evolution of the magnetization m based on Bloch-equation simulations. For this purpose, for example the simulation software MATLAB (The MathWorks; Natick, MA) can be used. The magnetization vector $m_l = (m_l^x, m_l^y, m_l^z)^T \in \mathbb{R}^3$ describes the initial magnetization after the inversion pulse as $\boldsymbol{m}_0 = [0,0,-1]^T$, assuming perfect inversion. The magnetization at the end of the $l$th measurement can then be described as

$$m_l = S(E_l R_x(k\,\alpha_l)m_{l-1} + (Id - E_l)[0,0,1]^T),$$

where $R_x(k\,\alpha)$ denotes a rotation about the x-axis by the angle $\alpha$ induced by the excitation pulse. To compensate for deviations from the nominal flip angle due to imperfect excitation slice-profiles and inhomogeneities in the transmit field, a $B_1^+$ correction may be implemented. Performing such a correction of the RF-field $B_1$ can be advantageous for quantification accuracy, as $B_1$ is generally not homogeneous and thus the flip angle of the excitation pulse can differ from what is expected according to the nominal field strength. The dictionary may be extended to allow for a $B_1^+$ amplitude correction using a linear scaling factor $k$ in the range of 0.6-1.4 in steps of 0.1. The step size may be set to 0.1 to limit the size of the dictionary, as the dictionary size scales linearly with the number of steps. $Id \in \mathbb{R}^{3x3}$ denotes the identity matrix, $s$ = [0 0 0; 0 0 0; 0 0 1] represents the spoiling of the transverse magnetization at the end of each measurement and $E_l$ is the diagonal relaxation matrix:

$$E_l = \begin{pmatrix} e^{-TR_l/T_2^*} & & \\ & e^{-TR_l/T_2^*} & \\ & & e^{-TR_l/T_1} \end{pmatrix}.$$

While $T_2^*$ dephasing is generally described by a non-exponential signal decay, the use of a single exponential decay as approximate signal model is the most used method. To allow for comparability to this method, single exponential mapping may be used for $T_2^*$ quantification. According to an example carried out by the inventors, the MRF dictionary consisted of 157,938 entries with the following parameter range: $T_1$=20-2,000ms in steps of 10ms, and 2,000-6,000ms in steps of 500ms; $T_2^*$=10-100ms in steps of 2ms, and 100-300ms in steps of 5ms. Unrealistic entries with $T_1 < T_2^*$ may be discarded.

Pattern validation:

The maximum TE of the TE pattern may be chosen by calculating the quantification precision of $T_2^*$ in depend-ence of various TE patterns. Fingerprints in the range of $T_1$=1000ms and $T_2^*$=50-250ms may be simulated by linearly scaling the TE pattern so that $TE_{max}$ is in the range of 14-100ms and matched to the dictionary in the presence of noise. The SNR may be set to 10, each fingerprint may be matched 10,000 times with different noise, and the remaining sequence parameters may be simulated as described above.

To ensure separability of the dictionary elements in the presence of noise, the stability of the parameter quantification from MRF data was studied, thereby testing the influences of noise on the fingerprints. For this the inverse problem describing the parameter extraction from MRF data *f* was locally linearized. Two exemplary relaxation constants set in the in-vivo range and the noise amplification, induced by the inverse problem as a function of the overall number of images in the fingerprint, was analyzed. The MRF system was linearized for variable fingerprint length *m*

$$f_m(\theta + \Delta\theta) = f_m(\theta) + J_{f_m}(\theta)\,\Delta\theta + o(|\Delta\theta|)$$

Here $f_m: \mathbb{R}^3 \mapsto \mathbb{R}^m$ describes the Bloch-simulation, just as commonly used in MRF to generate the magnitude fingerprints, from simulated parameter values $\theta = [T_1, T_2^*, M_0]$. $f_m$ is a continuous function in $\theta$. $J_{f_m}(\theta)$ denotes the corresponding Jacobian Matrix for the parameters $\theta$. In linear approximation the error amplification in the recovery of parameters ($\theta + e$) from the noisy fingerprint (v + n) can be described as

$$v + n = f_m(\theta + e) = f_m(\theta) + J_{f_m}(\theta)\,e + o(|e|) \xRightarrow{f_m(\theta)=v} e = J_{f_m}(\theta)^+\,n + o(|e|),$$

Where $J_{f_m}(\theta)^+$ denotes the pseudo-inverse of the Jacobian. The noise vector *n* is assumed to be normally distributed with zero mean and standard-deviation $\sigma$, $n \sim N(0, \sigma^2)$. For sufficiently large SNR, $o(|e|)$ can be neglected and is ignored for the rest of the analysis. To represent equal scan time, the noise variance $\sigma^2$ is normalized by the number of images ($\sigma^2 = m\,\sigma_0^2$), i.e. a lower number of images can be acquired with increased SNR. In the linear approximation, it follows that the components of e are normally distributed, as a sum of normal distributions in the noise input. Specifically, $e_{T_1} \sim N(0, \sigma_{T_1}^2)$ and $e_{T_2^*} \sim N\left(0, \sigma_{T_2^*}^2\right)$. The variance of the error vector can then be described, as a result from the sum of normal distributions:

$$\sigma_{T_1}{}^2 = \sigma^2 \sum_{i=1}^{m} \left| j_{1i}^+(\theta) \right|^2,$$

with $j_{ik}^+(\theta)$ denoting the elements of the pseudo inverse of the Jacobian matrix, $J_{fm}(\theta)^+$. Normalized by the variance of the input noise, it follows

$$\frac{\sigma_{T_1}}{\sigma_0} = \sqrt{m \sum_{i=1}^{m} \left| j_{1i}^+(\theta) \right|^2}, \frac{\sigma_{T_2^*}}{\sigma_0} = \sqrt{m \sum_{i=1}^{m} \left| j_{2i}^+(\theta) \right|^2}.$$

$\frac{\sigma_{T_1}}{\sigma_0}$ and $\frac{\sigma_{T_2^*}}{\sigma_0}$ were used to describe the noise amplification in the parameter recovery from MRF data, at various number of images. To study the noise amplification, two linearization points $\theta_G$, $\theta_W$, were chosen to correspond to gray- and white-matter ($T_1$, $T_2$, $M_0$ = 1800ms, 50ms, 1/1000ms, 40ms, 1) and the noise amplification $\frac{\sigma_{T_1}}{\sigma_0}$ and $\frac{\sigma_{T_2^*}}{\sigma_0}$ was calculated for fingerprint length of $3 \le m \le 3000$.

All dictionaries were computed in approximately 10 minutes using a standard desktop computer.

**Fig. 3A** shows exemplary fingerprints of 40 dictionary elements with varying $T_1$ (500ms-3000ms) and $T_2^*$ (10ms-100ms) values. Major contrast variations in the fingerprints are observed at various simulated $T_1$ and T2*.

**Fig. 3B** shows the dependency of the precision from $TE_{max}$. For short $T_2^*$ values a TE pattern with small $TE_{max}$ provides sufficient precision, for long $T_2^*$ values > 200ms, the gradient of the precision curve does not saturate at $TE_{max}$=100ms. $TE_{max}$=75ms was chosen as a compromise between precision and measurement time which gives sufficient precision in the in-vivo range of $T_2^*$ (<150ms).

Pattern matching

Dictionary matching may be performed by calculating the inner product between the magnitude of the dictionary entries and the magnitude of the measured signal. Dictionary matching based on correlation corresponds to a grid search minimization of the least squares error. This represents a maximum likelihood estimator for Gaussian noise. Hence, the Rician noise distribution, commonly observed in MRI magnitude data, potentially induces inaccuracy in the parameter estimation. To study the effect of Rician noise on the accuracy of the magnitude based dictionary matching, numerical simulations have been performed. Rician in noise was added to a simulated signal with relaxation times the in-vivo range ($T_1/T_2^*$=1000-2000ms/30-130ms) to generate SNR values between 2 and 10. For each SNR value, 5000 signals with added noise were matched to the dictionary and the average difference between the matched and original relaxation parameters was calculated.

Sequence parameters:

According to an example, imaging was performed on a 3 T whole-body scanner (Magnetom Trio; Siemens Healthcare, Erlangen, Germany) using the whole body coil for transmission. A 32-channel head receiver array was used for in-vivo measurements and a flex coil in combination with the spine coil for phantom scans. This study was approved by the local institutional review board (IRB) and all subjects provided written informed consent, prior to examination. The following image parameters were used for all MRF-EPI phantom and in-vivo measurements: bipolar k-Space trajectory, TE/TR = 14-75ms/48-109ms, flip angle = 0 - 58°, matrix/FOV = 128x128/220x220mm$^2$, BW = 1395Hz/pixel, slice thickness = 5mm, total gradient moment per spoiler = 69,6mT/m*ms, partial-Fourier = 6/8, parallel imaging factor = 3 with GRAPPA reconstruction, reference lines = 60 acquired in-place for each baseline image, gradient delay correction based on three navigator echoes, acquired prior to each readout, static geometric distortion correction, adaptive reconstruction of phased array, frames = 160, acquisition time per slice = 10s.

Reference values for $T_1$ were obtained using an inversion-recovery turbo spin-echo (IR-TSE) sequence with the following sequence parameters: 5 images, TI = 50-1600ms, TE/TR = 6ms/15s, turbo factor = 16, matrix/FOV=128x128/220x220mm$^2$, BW = 399Hz/pixel, scan time = 10min 0sec. To estimate $T_2^*$ times in phantoms, a spoiled gradient echo sequence (GRE) was employed and six images were acquired using the following parameters: TE = 5-80ms, TR = 1000ms, alpha = 15°, matrix/FOV = 128x128/220x220mm2, BW = 391 Hz/pixel, scan time = 12min 48sec.

For in-vivo measurements, a multi-gradient echo (GRE) sequence was employed due to shorter scan time, twelve images were acquired using the following parameters: TE = 5 - 80ms, TR = 300ms, alpha = 25°, matrix / FOV = 128 x 128 / 220 x 220mm$^2$, BW = 391Hz/pixel, echo spacing: 7ms, scan time = 39sec. Reference values for $T_1$ and $T_2^*$ were determined voxel-wise, fitting a three-parameter model for $T_2^*$ $\left(ae^{-t/T_2^*} + c\right)$ and two-parameter model for $T_1$ ($a(1 - e^{-t/T_1})$) to the image magnitudes using a nonlinear least-squares fitting algorithm.

In each MRF-EPI acquisition, one slice was acquired as proof of concept. In-vivo measurements consisted of three consecutive single MRF-EPI acquisitions.

Phantom experiments:

The effectiveness of gradient and RF spoiling of the MRF-EPI was tested in phantoms. The spoiling gradients were played with equal polarity both before and after the fat saturation pulse. In order to validate the thorough suppression of fat and water frequency components, 10 MRF-EPI measurements of a two compartment phantom containing fat and water were obtained. SNR for phantom and in-vivo measurements was calculated as following: $R = \dfrac{S_{mean}}{\sqrt{\frac{2}{4-\pi}}\,\sigma_{stdv}}$, where $S_{mean}$ is the average signal in the magnitude image, $\sigma_{stdv}$ is the standard deviation in a noise area of the magnitude images and $\sqrt{\dfrac{2}{4-\pi}}$ is a correction factor for the Rayleigh distribution of background noise in magnitude images.

To validate the quantification accuracy of MRF-EPI, phantom experiments were performed and compared to gold standard sequences. Separate measurements of nine phantoms were preformed, each with a single gadoterate-meglumine (Dotarem; Guerbet, Villepinte, France, concentration: 0.075-0.15$\mu$mol/ml) doped agarose compartment (concentration: 0.5-1.5w/w%). The accuracy of MRF-EPI was assessed by comparing the mean relaxation times in manually drawn ROIs delineating each phantom. Average deviations from the reference sequences were evaluated for both MRF data with and without $B_1^+$ correction.

The difference between complex and magnitude matching was tested by acquiring ten complex valued EPI-MRF measurements of each phantom. $T_1$ and $T_2^*$ were quantified using both complex and magnitude matching. The corresponding precision defined as the variation across the 10 repetitions was calculated for each matching method. For complex matching, the dictionary equation was extended for off resonance by including the factor $R_z(\varphi_l)$

$$m_l = S(E_l R_z(\varphi_l) R_x(k\,\alpha_l) m_{l-1} + (Id - E_l)[0,0,1]^T),$$

which denotes rotation about the z-axis by the angle $\varphi_l = 2\pi f TR_l$ with the off-resonance frequency $f$ in a range of 0-40Hz in steps of 2Hz.

**Fig. 4A** shows T1 and $T_2^*$ maps obtained in phantom measurements using MRF-EPI according to a preferred embodiment of the method according to the present invention and the respective reference method IR-TSE and GRE. Visually comparable image quality is observed between MRF-EPI and the gold standard in the T1 maps. Slightly decreased homogeneity throughout the phantom compartments is obtained in the $T_2^*$ maps, due to unavoidable field inhomogeneities.

**Fig. 4B** shows a comparison of T1 and $T_2^*$ values of MRF-EPI according to a preferred embodiment of the method according to the present invention with the reference methods. The comparison showing good agreement between the average relaxation times in all phantoms.

In particular, as shown in Figs. 4A and 4B, the proposed method with $B_1^+$ correction yields homogenous $T_1$ estimates within the phantoms. All $T_2^*$ maps show a higher degree of variation than $T_1$ maps, due to unavoidable susceptibilities and large field inhomogeneities influencing the $T_2^*$ values. Without $B_1^+$ correction, both $T_1$ and $T_2^*$ times are substantially underestimated using MRF-EPI ($T_1$ deviation from IR-TSE in the range from -18% to -5%, $T_2^*$ deviations from GRE in the range from -15% to 13%).

This trend is mitigated by including a $B_1^+$ correction in the matching of the MRF-EPI sequence, resulting in slight, residual underestimation of $T_1$ values (deviation: -2$\pm$3% [min: -5%, max 2%]), and a decreased deviation from the reference $T_2^*$ times (deviation: 2$\pm$3% [min: -4%, max 4%]).

**Fig. 5A** shows that complex matching results in a 2-fold (2.2$\pm$0.7) and 3-fold (3.0$\pm$1.0) higher quantification variance than magnitude matching in phantom scans, for $T_1$ and $T_2^*$ respectively. **Fig. 5B** shows that the quantified relaxation times of the phantoms are nearly identical for magnitude and complex matching (deviation of complex from magnitude matching $T_1/T_2$*: $0\pm1\%$ / $-2\pm2\%$).

In-vivo experiments

In-vivo images of six volunteers (4 females, 2 males $26\pm2$ years old) were acquired in three imaging slices each. In-vivo parameters maps were obtained with the proposed MRF-EPI and compared with the IR-TSE and the GRE sequence, for $T_1$ and $T_2$* measurements, respectively. To quantitatively compare the accuracy, $T_1$ and $T_2$* values were obtained for white and gray matter by manually placing ROIs in the parietal lobe and in the cortex of the frontal lobe and comparing the mean relaxation times. The images were masked for displaying purpose.

MRF-EPI data was successfully acquired in all volunteers. The achieved image quality allowed for further post-processing of all data sets.

**Fig. 6** shows an exemplary fingerprint of a healthy subject. MRF baseline images show high image quality with no visible imaging artifacts. Strongly varying $T_1$ and $T_2$* weighting can be observed over the course of the measurement. The signal intensity periodically increases and decreases due to the sinusoidal choice of the FAs.

**Fig. 7** shows representative $T_1$ and $T_2$* maps of the MRF-EPI and the gold standard measurements from one healthy subject. The mean $T_1$ and $T_2$* values obtained with MRF-EPI and gold standard sequences measured in manually drawn ROIs were: white matter $831\pm62$ms/$50\pm1$ ms (MRF-EPI), $790\pm56$ms/$48\pm3$ms (gold standard), gray matter: $1818\pm175$ms/$50\pm4$ms (MRF-EPI), $1751\pm131$ms/$48\pm6$ms (gold standard). $T_1$ maps are homogenous throughout gray and white matter, respectively. $T_2$* maps show detailed structures and intracerebral susceptibilities. Strong $T_2$* shortening is apparent close to tissue / air interface at the auditory canal or the sinus.

Within the present disclosure, an EPI based MRF method that allows for rapid quantification of $T_1$ and $T_2$* times in 10 seconds per slice is provided. Good quantification accuracy can be achieved in phantom scans, comparable to previously proposed methods. In-vivo scans yield robust and artifact free parameter maps, with in-vivo relaxation parameter values that are in good agreement with the reference scans.

In comparison to a spiral readout of the bSSFP-MRF, the EPI-MRF single shot acquisition according to an embodiment of the present invention is considerably slower, as it does not allow for the same level of undersampling. Therefore, only a reduced number of frames can be acquired during a 10 second measurement, despite the use of parallel imaging to accelerate data acquisition. However, the fewer frames benefit from higher SNR.

Spiral imaging requires accurate calibration and complex post-processing algorithms to alleviate effects of hardware inaccuracies. Despite excellent readout gradient efficiency and good undersampling properties, spiral imaging has rarely found integration into clinical scan-protocols. This highly restricts the availability of the required calibration and necessary post-processing schemes to a limited number of centers world-wide. EPI and accompanying post-processing techniques to reduce distortion and gradient deviation induced image quality deterioration, on the other hand, are readily available for clinical usage and highly accessible at almost all clinical MRI systems.

Recent data indicated sensitivity of MRF parameter quantification to system imperfections, due to inherent properties of the non-Cartesian data acquisition, as shown for radial imaging. Spiral imaging is well known to also suffer from substantial image quality degradation in the presence, of gradient deviations and trajectory mismatches, for example caused by eddy current effects. This could potential translate into quantification errors in a MRF acquisition. Bipolar EPI imaging on the other hand, is commonly performed with auto-calibration to compensate for gradient delay errors and eddy current effects, providing a certain degree of robustness to this source of system imperfection.

Previously proposed realizations of the MRF idea were based on SSFP sequences, which potentially cause additional hardware specific inaccuracies. Firstly, this introduces susceptibility to banding artifacts. Therefore, most recent MRF sequences were based on non-balanced SSFP sequences alleviating off-resonance sensitivity for the trade-off against a drop in SNR. Secondly, to obtain uncompromised signal in a SSFP acquisition, the spin-echo character of the sequence needs to be maintained, despite varying flip-angles. Thirdly, long trains of SSFP sequences are known to suffer from incomplete gradient refocusing, potentially introducing phase accumulation errors. However, especially in the presence of spiral gradients accurate rewinding poses a challenging problem.

The proposed method is based on gradient and RF spoiled imaging, which is resilient to banding-artifacts and incomplete gradient refocusing, and potentially allows for arbitrary flip-angles. Sequences based on EPI readout suffer from their own set of challenges. The most common artifacts are geometric distortions due to mistiming or inaccuracy in the gradient amplitude induced by residual eddy currents. Field inhomogeneities can further lead to blurring, Nyquist ghosting and signal loss, the latter often seen in the temporal and frontal lobes. As these effects have long been target of research, robust algorithms are available for most of the named artifacts, such as acquiring flied maps to correct geometric distortions. With the presence of solid correction algorithms, EPI compatible MRI hard- and software is installed worldwide and supported by commercial vendors throughout the world, providing robust EPI sequences used in clinical routine. Given the distinct profile of artifacts and sensitivity to hardware inaccuracies compared with spiral SSFP MRF sequences, the proposed implementation might offer a complimentary approach to study and utilize the MRF paradigm.

The proposed method was used to jointly assess $T_1$ and $T_2^*$ tissue characteristics. Both have been shown to be of clinical interest as highly specific biomarkers for distinct pathologies. The original MRF method proposed the joint quantification of $T_1$ and $T_2$ maps. This can also be achieved in MRF-EPI by employing refocused EPI readouts to induce $T_2$ weighting. Increased SNR can be expected in refocused EPI readouts and the real part of the imaging data, can be readily used in post-processing due to the elimination of off-resonance dependencies. Hence, MRF-EPI also bares promise for robust $T_1$ and $T_2$ quantification.

The proposed method employed a simplified $B_1^+$ correction compared to previous studies, where the inventors proposed to alter the flip-angle scheme in order to increase $B_1+$ estimation accuracy. However, to demonstrate feasibility in a comparable fashion to the original MRF method, the original flip-angle scheme was employed, accepting a slight drop in accuracy. Nevertheless, incorporating $B_1^+$ estimation in the dictionary greatly improved parameter estimation, while the resulting $B_1^+$ map possibly suffers from systematic errors. Furthermore, to avoid the susceptibility to off-resonances the magnitude data was used for pattern matching. Complex matching of the data can be employed to derive additional off resonance maps. However, the increased number of fit parameters results in lower quantification precision. Therefore, magnitude matching was chosen for MRF-EPI. As the correlation based pattern matching requires zero mean noise, a violation of this assumption potentially compromises the accuracy. However, due to sufficient base-line SNR, the detrimental effect can be expected to be small. Alternative reconstructions based on a Rician noise maximum likelihood estimation could be used to further mitigate this effect. However, the potential gain in accuracy comes at the cost of greatly increased computational time.

In summary, a MRF sequence with spoiled EPI readout is proposed according to a preferred embodiment of the present invention. In particular, according to a preferred embodiment, a pulse sequence for acquiring MRF data based on spoiled EPI readouts for joint $T_1$ and $T_2^*$ quantification is proposed, as an alternative to balanced non-Cartesian imaging, potentially facilitating improved robustness and increased usability. Rapid $T_1$ and $T_2^*$ quantification can be performed within 10 seconds per slice and yield in-vivo relaxation parameter maps of high quality. Using EPI for MRF fosters its usability and offers a complementary approach to existing MRF sequences. In other words, the proposed MRF method (MRF-EPI) according to a preferred embodiment is based on the acquisition of a plurality (e.g. 160) gradient-spoiled EPI images with rapid, parallel-imaging accelerated, Cartesian readout and a measurement time of 10s per slice. Contrast variation is induced using an initial inversion pulse, and varying the flip-angles, echo-times, and repetition-times throughout the sequence. Joint quantification of $T_1$ and $T_2^*$ is performed using dictionary matching with integrated $B_1^+$ correction.

Joint T1 and $T_2^*$ parameter-maps acquired with MRF-EPI in phantoms are in good agreement with reference measurements, showing deviations under 5% and 4% for T1 and T2*, respectively. In-vivo baseline images were visually free of artifacts. In-vivo relaxation times are in good agreement with gold-standard techniques (deviation T1:$4\pm2\%$, T2*:$4\pm5\%$). The visual quality is comparable to the in-vivo gold standard, despite substantially shortened scan-times.

In particular, with the method according to the present invention, an implementation of the magnetic resonance fingerprinting (MRF) paradigm is provided for quantitative imaging, preferably by using echo-planar imaging (EPI) for simultaneous assessment of $T_1$ and T2*.

The proposed method enables fast and accurate T1 and $T_2^*$ quantification. In particular, the proposed method offers a rapid supplement to the non-Cartesian MRF portfolio, with potentially increased usability and robustness.

Applicant: Universität Heidelberg

"Method, computer program product and apparatus for analysing an object by means of nuclear magnetic resonance imaging"

Our Ref.: H 3665EU - ds / msc

**List of Reference Numerals**

1    pulse sequence
2    preparation phase
3    acquisition phase / acquisition of N sets of imaging data
4    inversion pulse
5    excitation step / excitation module / excitation pulse
6    image readout step / image readout module / Echo Planar Imaging (EPI)
7    spoiling step / spoiling module / depletion of the transversal magnetization (spoiling)
8    fat saturation step / fat saturation module

**Claims**

1.  Method for analysing an object by means of nuclear magnetic resonance imaging, the method comprising:

    - issuing a pulse sequence (1) to an NMR apparatus, the pulse sequence (1) comprising a plurality of acquisition phases (3);
    - within a respective acquisition phase (3), acquiring a corresponding set of imaging data; and
    - quantifying at least one contrast parameter of the object based on the acquired sets of imaging data and simulated data;

    wherein the acquisition phase (3) comprises the following steps in the given order:

    -- an excitation step (5) for flipping a longitudinal magnetization of one or more nuclear spins in the object into a transversal plane by a variable flip-angle, thereby inducing a transversal magnetization;
    -- an image readout step (6) for reading out the corresponding set of imaging data; and
    -- a spoiling step (7) for depleting the transversal magnetization;

    wherein a timing of the steps and/or the flip-angle is varied between at least two of the plurality of acquisition phases (3).

2.  Method according to claim 1, wherein the image readout step (6) is based on a Cartesian readout.

3.  Method according to claim 1 or 2, wherein the image readout step (6) comprises an Echo Planar Imaging.

4.  Method according to any one of the preceding claims, wherein the acquisition phase (3) further comprises

    -- a fat saturation step (8).

5.  Method according to any one of the preceding claims, wherein the pulse sequence (1) further comprises one or more preparation phases (2) before or during the plurality of acquisition phases (3).

6.  Method according to claim 5,
    wherein the one or more preparation phases (2) comprise one or more inversion pulses (4), and/or
    wherein the one or more preparation phases (2) comprise one or more depletion pulses for depleting the transversal magnetization, and/or
    wherein the one or more preparation phases (2) comprise one or more fat suppression pulses.

7.  Method according to any one of the preceding claims, wherein the step of quantifying at least one contrast parameter of the object comprises jointly quantifying the longitudinal relaxation time T1 and the transversal relaxation time T2*.

8.  Method according to any one of the preceding claims, wherein the step of quantifying at least one contrast parameter of the object comprises a dictionary matching or a simulated annealing.

9.  Method according to any one of the preceding claims, wherein the spoiling step (7) is performed directly after performing the image readout step (6).

10. Method according to any one of the preceding claims, wherein the spoiling step (7) comprises gradient spoiling or radio frequency spoiling.

11. Method according to any one of the preceding claims, wherein the applied pulse sequence (1) is based on a non-balanced sequence design.

12. Computer program product comprising a computer readable storage medium having encoded thereon instructions that, when executed on a processor, cause the processor to perform a method according to any one of the preceding claims.

13. Control apparatus for NMR comprising a processor being configured to perform a method according to any one of claims 1 to 11.

**14.** Nuclear magnetic resonance apparatus comprising:

- a magnet system for generating a main magnetic field;
- a gradient system for generating gradient fields;
- a radio frequency system for generating radio frequency pulses; and
- a control apparatus according to claim 13.

Fig. 1

Fig. 2

Fig. 3

A)

$T_1$: 1200$ms$

$T_2^*$ (ms)

100

45

10

$T_2^*$: 60$ms$

$T_1$ (ms)

3000

1750

500

Signal (a.u.)

Measurement #

B)

MRF-EPI
$TE_{max}$=75ms

Precision (ms)

$TE_{max}$ (ms)

$T_2^*$ (ms)

250

150

50

EP 3 336 570 A1

Fig. 4

Fig. 5

A)

B)

Fig. 6

Fig. 7

EP 3 336 570 A1

23

Europäisches
Patentamt

European
Patent Office

Office européen
des brevets

# EUROPEAN SEARCH REPORT

**Application Number**

EP 16 20 4442

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2016/282436 A1 (CLOOS MARTIJN ANTON HENDRIK [US]) 29 September 2016 (2016-09-29) * paragraph [0035] - paragraph [0070]; figures 5-8, 12 * | 1-14 | INV. G01R33/50 G01R33/56 G01R33/561 G01R33/565 |
| L | DAN MA ET AL: "Magnetic resonance fingerprinting", NATURE, vol. 495, no. 7440, 13 March 2013 (2013-03-13), pages 187-192, XP055183037, ISSN: 0028-0836, DOI: 10.1038/nature11971 * the whole document * * This document completes the disclosure of the method of document US 2016/0282436, which explicitly makes reference to XP055183037 in paragraph [0003] * | 1-14 | ADD. G01R33/48 G01R33/483 |
| X | US 2012/326721 A1 (REMMELE STEFANIE [DE] ET AL) 27 December 2012 (2012-12-27) * paragraph [0056] - paragraph [0065]; figures 2c, 3 * | 1-14 | |
| X | US 2010/213938 A1 (JEONG EUN-KEE [US] ET AL) 26 August 2010 (2010-08-26) * paragraph [0023] - paragraph [0063]; figure 1 * | 1-3,5,6, 9-14 | |

**TECHNICAL FIELDS SEARCHED (IPC)**

G01R

-/--

The present search report has been drawn up for all claims

| Place of search | Date of completion of the search | Examiner |
|---|---|---|
| Munich | 14 June 2017 | Raguin, Guy |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**EUROPEAN SEARCH REPORT**

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | JOHN D BIGLANDS ET AL: "Cardiovascular magnetic resonance physics for clinicians: part II", JOURNAL OF CARDIOVASCULAR MAGNETIC RESONANCE, BIOMED CENTRAL LTD, LONDON UK, vol. 14, no. 1, 20 September 2012 (2012-09-20), page 66, XP021134234, ISSN: 1532-429X, DOI: 10.1186/1532-429X-14-66 * figures 3, 4, 10, 11 * | 1-6,9-11 | |
| T | BENEDIKT RIEGER ET AL: "Magnetic resonance fingerprinting using echo-planar imaging: Joint quantification of T 1 and T2* relaxation times", MAGNETIC RESONANCE IN MEDICINE., 16 December 2016 (2016-12-16), XP055381118, US ISSN: 0740-3194, DOI: 10.1002/mrm.26561 * the whole document * | 1-14 | |
| A | US 2016/349339 A1 (BRADY-KALNAY SUSANN [US] ET AL) 1 December 2016 (2016-12-01) * the whole document * | 1-14 | TECHNICAL FIELDS SEARCHED (IPC) |

The present search report has been drawn up for all claims

| Place of search | Date of completion of the search | Examiner |
|---|---|---|
| Munich | 14 June 2017 | Raguin, Guy |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 16 20 4442

This annex lists the patent family members relating to the patent documents cited in the above-mentioned European search report.
The members are as contained in the European Patent Office EDP file on
The European Patent Office is in no way liable for these particulars which are merely given for the purpose of information.

14-06-2017

| Patent document cited in search report | | Publication date | Patent family member(s) | | Publication date |
|---|---|---|---|---|---|
| US 2016282436 | A1 | 29-09-2016 | EP | 3068298 A2 | 21-09-2016 |
| | | | US | 2016282436 A1 | 29-09-2016 |
| | | | WO | 2015073894 A2 | 21-05-2015 |
| US 2012326721 | A1 | 27-12-2012 | CN | 102859386 A | 02-01-2013 |
| | | | EP | 2548039 A1 | 23-01-2013 |
| | | | JP | 6050126 B2 | 21-12-2016 |
| | | | JP | 2013521922 A | 13-06-2013 |
| | | | US | 2012326721 A1 | 27-12-2012 |
| | | | WO | 2011114264 A1 | 22-09-2011 |
| US 2010213938 | A1 | 26-08-2010 | NONE | | |
| US 2016349339 | A1 | 01-12-2016 | NONE | | |

EPO FORM P0459

For more details about this annex : see Official Journal of the European Patent Office, No. 12/82